# EUROPÄISCHE PATENTSCHRIFT

(11) **EP 1 050 395 B1**
(45) Veröffentlichungstag und Bekanntmachung des Hinweises auf die Patenterteilung: **07.07.2004**
(21) Anmeldenummer: 00109352.5
(22) Anmeldetag: 02.05.2000
(51) Int. Cl.: B29C 59/16

(54) **Offener UV/VUV-Excimerstrahler und Verfahren zur Oberflächenmodifizierung von Polymeren**
Open uv/vuv excimer radiator and method for surface modification of polymers
Radiateur excimere uv/vuv ouvert et procédé pour la modification de la surface de polymères

(30) Priorität: 05.05.1999 DE 19920693
(43) Veröffentlichungstag der Anmeldung: 08.11.2000
(73) Patentinhaber: Institut für Oberflächenmodifizierung e.V., 04303 Leipzig (DE)
(72) Erfinder: Mehnert, Reiner, Prof. Dr. rer.nat. habil, 04416 Markkleeberg (DE); Lenk, Martin, Dipl.-Phys., 04207 Leipzig (DE)
(74) Vertreter: Köhler, Tobias, Dipl.-Ing.(FH)

(56) Entgegenhaltungen:
- DE-A- 3 620 214
- DE-A- 4 332 866
- DE-A- 19 717 698
- US-A- 5 266 244
- US-A- 5 549 780

## Beschreibung

Die Erfindung betrifft einen offenen UV/VUV- Excimerstrahler gemäß dem Oberbegriff des Patentanspruchs 1 sowie ein Verfahren zur Oberflächenmodifizierung von Polymeren, gemäβ dem Oberbegriff des Patentanspruchs 4 und ein Verfahren Gemäβ dem Oberbegriff des Patentanspruchs 5.

Bekannte gattungsgemäße Excimerstrahler bestehen aus einer abgeschlossenen Entladungskammer, die mit dem Excimergasgemisch gefüllt ist. Das zu bestrahlende Medium befindet sich im Falle von UV - Strahlern meist außerhalb der Entladungskammer; dabei muss die erzeugte Excimerstrahlung ein Fenster, in der Regel aus Quarzglas, durchdringen.
Beschrieben sind solche geschlossenen Strahler beispielsweise in der EP O 254 111 A1, der CH 676 168 A5 und der CH 675 178 A5.

Eine weitere Veröffentlichung zu geschlossenen Strahlern beinhaltet das J. Opt. Technol., Vol. 65, 1998, S. 1026 - 1028 von L. P. Shishatskaya, S. A. Yakovlev und G. A. Volkova.

Im Falle von VUV- Strahlern müssen entweder spezielle Fenstermaterialien, wie beispielsweise in der DE 40 10 190A 1 beschrieben, verwendet werden, vorzugsweise Magnesiumfluorid, oder das Medium wird selbst in die Entladungskammer eingebracht.

Allgemein angewandte Grundlagen sind den folgenden Veröffentlichungen zu entnehmen:

U. Kogelschatz: "Proceedings of the Tenth International Conference on Gas Discharges and their Applications", Vol. II, Swansea 1992; B. Eliasson und U. Kogelschatz: "Nonequilibrium Volume Plasma Chemical Processing", IEEE Transactions on Plasma Science 19/6, S. 1063 - 1077 (1991) sowie H. Esrom und U. Kogelschatz: Applied Surface Science 54 (1992) S. 440- 444

Bisher sind Excimerstrahler bekannt, die aus einer abgeschlossenen Entladungskammer bestehen, die mit Excimergasgemischen, Edelgasen ohne oder mit Halogenanteilen, gefüllt sind.

Bekannt ist die Anregung des Excimergases durch Elektroden, beispielsweise in Form von parallelen Platten oder konzentrischen Rohren, mit einem trennenden Dielektrikum, welches mindestens aus einer Schicht aus massivem nichtleitendem Material, beispielsweise Quarzglas, besteht. Die bei der stillen Entladung erzeugte Excimerstrahlung dringt entweder direkt durch das Wandmaterial, z. B. Quarzglas, nach außen oder durch ein spezielles Fenster aus Quarz, Magnesiumfluorid oder ähnlichen Materialien.

Weiterhin bekannt ist die Anregung des Excimergases in einer geschlossenen Entladungs kammer mittels Mikrowelleneinspeisung aus der DE 43 02 555A1 sowie der Veröffentlichung von Furusawa, Hideki u. a. : "Highefficiency continuous operation HgBr excimer lamp excited by microwave discharge" in: Appl.Phys.Lett, Vol. 66, 1995, S. 1877-1879.

Die DE 43 42 643C2 beschreibt einen offenen Strahler in Tintenstrahldruckern. Dabei wird blanke Luft verwendet.
Der gemäß dieser Lösung eingesetzte Strahler ohne Excimerspectrum ist nicht den UV/VUV- Strahlern zuzuordnen.

*Aus dem Stand der Technik sind unterschiedliche Verfahren zur Oberflächenmodifzierung bekannt.*
*So sind Verfahren bekannt, welche eine Oberflächenbehandlung mittels reinen Plasmas vorschlagen.*

*Beispielsweise seien dazu benannt die US-Schrift 5549780, welche ein Verfahren zur Plasmabildung vorschlägt sowie die DE3620214 welche ein Verfahren zur Schaffung eines chemischen aktiven Milieus für plasmachemische Reaktionen und eine Vorrichtung zur Durchführung dieses Verfahrens vorschlägt.*

*Gemäß dieser Veröffentlichung wird ein aktivierbares Reaktionsgas durch eine Düse in Richtung der aktiven Zone unter Druck eingebracht.*
*In dem gemäß dieser Schrift verwendeten Reaktionsgas sind Ionen und Elektronen vorhanden, welche bei Auftreffen auf der bestrahlten Oberfläche zum Modifizieren führen.*

*Bekannt sind weiterhin Verfahren zur Modifizierung von Oberflächen mittels Barriereentladung in der Kombination mit UV- bzw. VUV- Licht*

*Dazu wurden mit der DE 4332866 und der DE 19717698 Verfahren und Vorrichtungen veröffentlicht, welche eingesetzt werden zur Reinigung von Oberflächen.*

*Dabei wird ohne Erwärmung der Oberfläche eine dielektrisch behinderte Entladung eingesetzt.*
*Die bei der dielektrisch behinderten Entladung entstehende UV- oder VUV- Strahlung wird dabei unterstützend bei der Oberflächenreinigung mitgenutzt.*

*Die dabei verwendete Vorrichtung weist einen konzentrischen Ringbereich um eine langgestreckte zylindrische Mittelelektrode als Barriereentladungsvorrichtung auf.*
*Dieser Ringbereich kann dabei der Entladungsraum eine Excimerstrahlers sein, wobei eine ebenfalls konzentrische äußere Elektrode lichtdurchlässig ist.*

*Bei Anwendung dieser Verfahren entstehen interne UV- bzw. VUV- Strahlungen, welche, bedingt durch das vorhandene Füllgas, absorbiert werden und deshalb nur bei extrem kurzem Abstand zwischen Entladungszone und der zu modifizierenden Oberfläche wirksam werden können.*

*Auch bekannt sind Verfahren zur Oberflächenmodifizierung mittels Excimerlaser, wie beschrieben in der US- Schrift 5266244.*
*Diese Lösung beschreibt eine Verfahren zum Herstellen elektrisch leitfähigem Polymerfilms durch Bestrahlung mittels gepulstem Excimerlaser mit einer Wellenlänge von 190-300nm.*
*Nachteilig bei diesem Verfahren sind die bei der Bestrahlung auftretenden hohen Temperaturen, welche zu einer thermomechanische Zerstörung führen.*

Ferner sind nach E. Esrom und U.Kogelschatz (Applied Surface Science 54 (1992) S. 440- 444) auch Anordnungen bekannt, die im VUV-Gebiet ohne Fenster auskommen.
Dabei wird das zu bestrahlende Substrat mit entsprechend kleinen Abmessungen in die abgeschlossene Anregungskammer eingebracht.

Nachteilig bei diesen bekannten Excimerstrahlern ist das technologische Erfordernis eines notwendigen Fensters aus Quarzglas oder, im VUV-Gebiet unterhalb einer Wellenlänge von 140 nm, das extrem teure Spezialfenster mit sehr begrenzten Abmessungen aus Calcium- oder Magnesiumfluorid oder ähnlichem Material.

Bei den bisher bekannten fensterlosen Anordnungen im UV/VUV- Bereich muss das Substrat mit in die Excimer-Anregungskammer eingebracht werden, was nur bei kleinen Abmessungen des Bestrahlungsgutes und nur bei kleineren Bestrahlungsserien möglich ist.
Bei Verwendung dieser Anordnung bei größeren Abmessungen des Bestrahlungsgutes und bei größeren Bestrahlungsserien wird der Einsatz einer aufwendigen Schleusentechnik notwendig.

Nachteiligerweise ist dieses Verfahren jedoch nicht für die industrielle Nutzung, etwa an Druck- oder Beschichtungsanlagen, anwendbar.

Der Erfindung stellt sich die Aufgabe, fensterlose UV- und VUV- Quellen zu entwickeln, die im Gegensatz zu den bisher bekannten Niederdruckformationen (0,1 bis 1 bar) unter Normaldruck arbeiten, sowie ein Verfahren zur Oberflächenmodifizierung mithilfe solcher Strahler anzugeben.

Die Aufgabe wird erfindungsgemäß durch einen offenen UV/VUV- Excimerstrahler nach Patentanspruch 1 sowie durch ein Verfahren nach Patentanspruch 4 bzw. Patentanspruch 5 gelöst.

Vorteilhafte Weiterbildungen der Erfindung sind Gegenstand der abhängigen Ansprüche 2 und 3.

Die Einspeisung des Excimergases in den erfindungsgemäßen Strahler erfolgt dabei oberhalb der Elektroden in eine Düsenkammer. Diese ist mittels eines Düsensystems mit dem unter der Düsenkammer angeordneten Entladungsraum verbunden.
In diesem Entladungsraum sind die Elektroden angeordnet. Unmittelbar darunter ist die Austrittsblende für die generierte Excimerstrahlung und das Anregungsgas, welches fortan als Inertgas wirkt, angeordnet.

Die in den Inertisierungskanal einfallende Strahlung trifft dabei auf das an seiner Oberfläche zu modifizierende Folienmaterial, und das nunmehr als Inertgas wirkende Excimergas strömt durch den Folieneintrittsspalt und den Folienaustrittsspalt nach außen und verhindert somit das Eindringen von Luftsauerstoff.

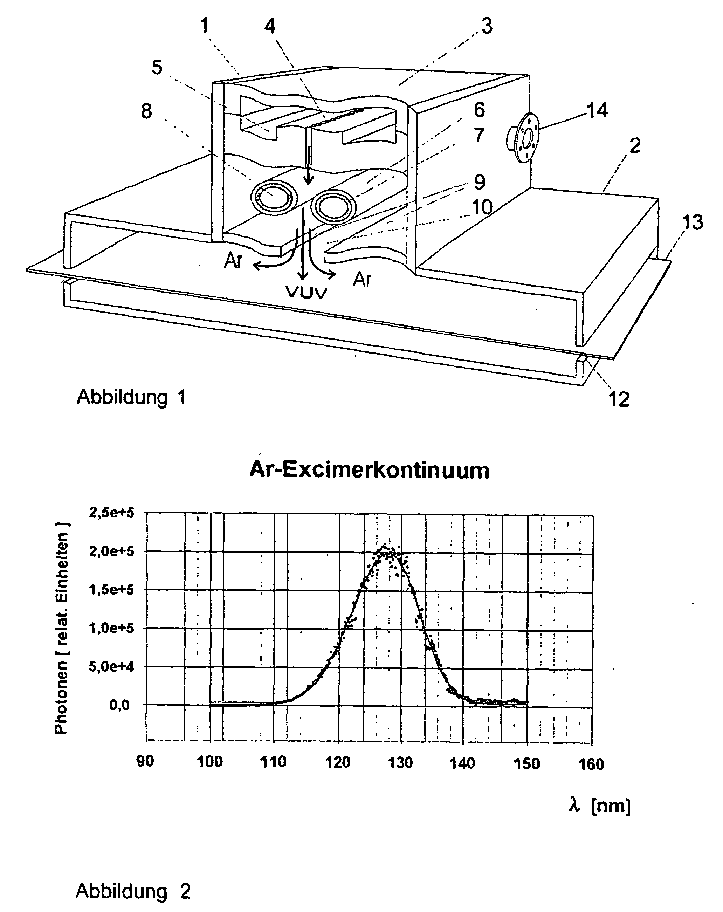

Die Erfindung soll an einem Ausführungsbeispiel und den Abbildungen 1 bis 3 näher erläutert werden.

Besonders interessant für die Oberflächenmodifizierung ist der Wellenlängenbereich unterhalb 140 nm wegen der in diesem Bereich möglichen Ionisationsprozesse.

Als Excimergas bietet sich hier wegen der Lage des Excimer-Kontinuums (125-130 nm) und des niedrigen Preises sehr gut Argon an.

Der erfindungsgemäße Strahler besteht aus dem Strahlerkopf 1 und dem Inertisierungskanal 2, die beide durch die Austrittsblende 9 und den Austrittsspalt 10 getrennt sind. Im oberen Teil des Strahlerkopfes ist der Düsenblock 3 mit den Ar-Einströmkanälen 5 und den Düsenbohrungen 4 angeordnet.
Darunter befinden sich die beiden Elektroden 7, die mit Quarzglas 6 umhüllt und an einen Mittelfrequenzgenerator angeschlossen sind.
*Das zu modifizierende Material 13 wird durch die Folienaustrittsöffnung 12 aus der Vorrichtung herausgeführt.*

In einer besonderen Ausgestaltung der erfindungsgemäßen Lösung können diese mit Wasser im Kühlkanal 8 betrieben werden.

Das Argon wird über eine Zuführung 14 in die Düsenkammer 3 eingebracht und gelangt über die Einströmkanäle 5 sowie die Düsenbohrungen 4 ausreichend homogen in den Entladungsraum 15 zwischen die Elektroden 7. Durch die Feldanregung der an einen Hochspannungs- Mittelfrequenz- Generator angeschlossenen quarzumhüllten Elektroden 7 kommt es zur Aussendung der VUV-Photonen des 2. Argon- Excimerkontinuums (Abb. 2).

Danach tritt die VUV-Strahlung und das nunmehr als Inertgas wirkende Argon durch das am Boden befindliche Austrittsblendensystem 9 und 10 in den Inertisierungs- und Bestrahlungsraum 2 ein, und es kommt zur Bildung freier Radikale auf der Oberfläche *des zu modifizierenden Materials 13.* Über die Breite des Austrittsspaltes 10 wird der Durchfluß und damit der Argonverbrauch eingestellt.

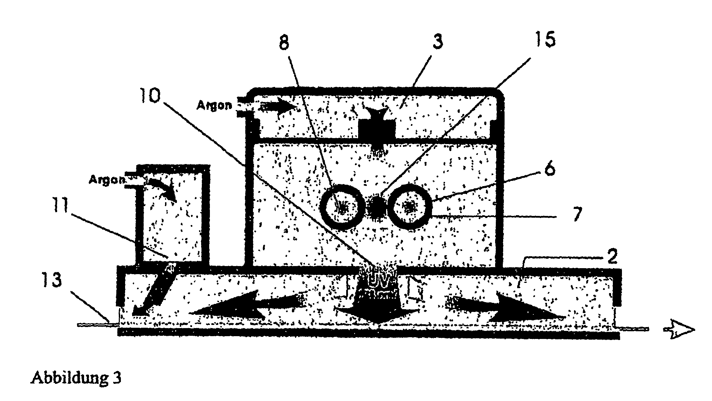

Der Strahler mit dem Inertisierungskanal 2 wird vorzugsweise an eine Vorinertisierung mit einer Schäldüse 11 angeschlossen (Abb. 3).
Dabei wird in einer besonderen Ausgestaltung der erfindungsgemäßen Lösung in Laufrichtung des zu modifizierenden Materials *13* vor dem Strahler eine zusätzliche Schäldüse *11* angeordnet.
Mittels dieser Schäldüse 11 wird Argon gegen die Laufrichtung des zu modifizierenden Materials 13 zugegeben, um auf dessen Oberfläche befindlichen Luftsauerstoff abzuschälen und das Eindringen von Luft durch die seitliche Öffnung des Argon- Inertisierungskanals 6 zu verhindern.

Die Vorteile der erfindungsgemäßen Lösung bestehen darin, dass das Excimergas im Entladungsraum gleichzeitig als Inertgas unmittelbar über der zu bestrahlenden Oberfläche verwendet wird und die sonst notwendigen Fenster aus Quarzglas oder Calcium- oder Magnesiumfluorid entfallen.

## Patentansprüche

1. Offener UV/VUV- Excimerstrahler zur Oberflächenmodifizierung von Polymeren, **dadurch gekennzeichnet, dass** das Excimergas gleichzeitig als Inertgas verwendbar ist und zum homogenen Einbringen des Excimergases unter Normaldruck zwischen Elektroden (7) oberhalb dieser Elektroden (7) eine Düsenkammer (3) angeordnet ist, in welcher sich ein Düsensystem (4 und 5) zur Verbindung zum Entladungsraum (15) befindet, dass die Elektroden (7) zur Excimeranregung in diesem Entladungsraum (15) angeordnet sind und dass zwischen dem Entladungsraum (15) und einem Inertisierungs- und Bestrahlungsraum (2) ein Blendensystem (9 und 10) angeordnet ist, durch welches die generierten UV/VUV- Photonen sowie die Excimergasmoleküle in den Inertisierungs- und Bestrahlungsraum (2) gelangen.

2. Excimerstrahler nach Anspruch 1, **dadurch gekennzeichnet, dass** zur Optimierung des Excimergasdurchflusses und des Excimergasverbrauches das Düsensystem (4 und 5) und das Blendensystem (9 und 10) aufeinander abstimmbar sind.

3. Excimerstrahler nach Anspruch 1, **dadurch gekennzeichnet, dass** in Laufrichtung des zu modifizierenden Polymer-Materials (13) vor dem Strahler eine zusätzliche Schäldüse (11) angeordnet ist.

4. Verfahren zur Oberflächenmodifizierung von Polymeren mittels eines Excimerstrahler gemäß Anspruch 1 zur Oberflächenmodifizierung von Polymeren, **dadurch gekennzeichnet, dass** das Excimergas unter Normaldruck zwischen den Elektroden (7) mittels eines geeigneten Düsensystems (4 und 5) homogen eingebracht und gleichzeitig als Inertgas verwendet wird.

5. Verfahren zur Oberflächenmodifizierung von Polymeren mittels gemäß eines Excimerstrahler nach Anspruch 1 erzeugtem VUV-Licht, **dadurch gekennzeichnet, dass** das Inertisierungsgas über eine Zuführung (14) permanent in den Düsenblock (3) eingebracht wird und sich in dem Düsenblock (3) in den Einströmkanälen (5) absetzt und den Düsenblock (3) allmählich füllt, dass nach Füllung des Düsenblockes (3) das Inertisierungsgas durch die Düsenbohrungen (4) in den Entladungsraum (15) und von diesem in den Inertisierungs- Kanal (2) eintritt und nach Ausfüllung desselben durch die seitlichen Öffnungen im Inertisierungs- Kanal (2) nach außen geführt wird und dabei andere Gase mit aus dem Strahler spült und dass mittels der im Entladungsraum (15) angeordneten Elektroden (7) das UV/ VUV- Licht erzeugt wird, welches durch den Austrittsspalt (10) im Boden des Entladungsraumes (15) auf die zu modifizierende Oberfläche des Polymer-Materials (13) auftrifft.

## Claims

1. Open UV-VUV excimer emitter for the surface modification of polymers, which is **characterized by** the excimer gas being usable as inert gas at the same time, a jet chamber (3) being arranged between the electrodes (7) above these electrodes (7) for the homogenous introduction of the excimer gas at normal pressure, the jet chamber (3) being equipped inside with a jet system (4 and 5) providing the connection to the discharge chamber (15), the electrodes (7) being located in this discharge chamber (15) for excimer activation, and a diaphragm system (9 and 10) being arranged between discharge chamber (15) and an inerting and radiation chamber (2) through which the UV-VUV photons generated as well as the excimer gas molecules can access to inerting and radiation chamber (2).

2. Excimer emitter according to Claim 1 which is **characterized by** the jet system (4 and 5) and the diaphragm system (9 and 10) being adjustable to each other for optimizing excimer gas flow and excimer gas consumption.

3. Excimer emitter according to Claim 1 which is **characterized by** an additional separation nozzle (11) being arranged in front of the emitter in the direction of the passage of the polymer material to be modified (13).

4. Process for surface modification of polymers by means of an excimer emitter according to Claim 1 which is **characterized by** the excimer gas being homogenously introduced between the electrodes (7) by means of a suitable jet system (4 and 5) at normal pressure and, at the same time, being used as inert gas.

5. Process for modifying the surface of polymers by means of a VUV light generated by means of an excimer emitter according to Claim 1 which is **characterized by** the inerting gas being permanently introduced into the nozzle block (3) via a feeding (14), then sedimenting in the admission channels (5) in nozzle block (3) thus gradually filling nozzle block (3), the inerting gas penetrating into the discharge chamber (15) through nozzle bore holes (4) and from there into inerting channel (2) after filling the nozzle block (3), and the inerting gas being guided outside through lateral openings in inerting channel (2) after filling inerting channel (2), taking other gases along with it and flushing them out of the emitter, the UV-VUV light being produced by means of the electrodes (7) installed in the discharge chamber (15) and striking the surface to be modified of the polymer material (13) through the exit gap (10) in the base of discharge chamber (15).

## Revendications

1. Émetteur ouvert à excimères de rayons UVNUV pour la modification des surfaces de polymères, **caractérisée en ce que** le gaz à excimères peut en même temps être utiliser comme gaz inerte, une chambre à tuyères (3) dans laquelle se trouve un système de tuyères (4 et 5) pour réaliser la connexion à la chambre de décharge (15) étant situé entre les électrodes (7) au-dessus de ces électrodes (7) pour l'introduction homogène du gaz à excimères sous pression atmosphérique standardisée, les électrodes (7) étant situées pour l'activation à excimères dans cette chambre de décharge (15), et un système de diaphragmes (9 et 10) étant situé entre la chambre de décharge (15) et la chambre d'inerting et d'irradiation (2) au travers lequel les photons UVNUV générés ainsi que les molécules gaz à excimères accèdent à la chambre d'inerting et d'irradiation (2).

2. Émetteur à excimères selon la revendication 1, **caractérisé en ce que**, pour l'optimisation du passage du gaz à excimères et de la consommation de gaz à excimères, le système à buses (4 et 5) et le système de diaphragmes (9 et 10) peuvent être mutuellement adaptés.

3. Émetteur à excimères selon la revendication 1, **caractérisé en ce qu'**une tuyère séparatrice supplémentaire (11) est arrangée devant le émetteur dans le sens de marche de la matière en polymères à modifier (13).

4. Procédure de modification des surfaces de polymères à l'aide d'un émetteur à excimères selon la revendication 1 pour la modification des surfaces de polymères, **caractérisée en ce que** le gaz à excimères est introduit homogènement sous pression atmosphérique standardisée entre les électrodes (7) par l'intermédiaire un système à tuyères approprié (4 et 5) et, en même temps, est utilisé comme gaz inerte.

5. Procédure de modification des surfaces de polymères à l'aide d'une lumière à rayons VUV générée par un émetteur à excimères selon la revendication 1, **caractérisée en ce que** le gaz d'inerting est en permanence introduit au bloc à tuyères (3) au travers d'une amenée (14) et se dépose dans les canaux d'admission (5) dans le bloc à tuyères (3), ainsi remplissant graduellement le bloc à tuyères (3), le gaz d'inerting pénétrant, après avoir rempli le bloc à tuyères (3), à la chambre de décharge (15) au travers les alésages des tuyères (4) et depuis cette dernière au canal d'inerting (2), étant mené vers l'extérieur au travers les ouvertures latérales dans le canal d'inerting (2), après avoir rempli ce dernier, ainsi balayant en les entraînant autres gaz à l'extérieur du émetteur, la lumière à rayons UVNUV qui rencontre à travers de la fente de sortie (10) dans le fond de la chambre de décharge (15) la surface à modifier de la matière de polymères (13) étant produite à l'aide des électrodes (7) arrangées dans la chambre de décharge (15).
